# EUROPEAN PATENT APPLICATION

(11) **EP 4 468 323 A1**
(43) Date of publication of application: **27.11.2024**
(21) Application number: 22922155.1
(22) Date of filing: 19.12.2022
(51) Int. Cl.: H01L 21/304, G05B 19/418, G05B 23/02, H01L 21/02

(54) **ASSISTANCE DEVICE, ASSISTANCE METHOD, AND ASSISTANCE PROGRAM**

(30) Priority: 19.01.2022 JP 2022006753
(71) Applicant: SCREEN Holdings Co., Ltd., Kyoto-shi, Kyoto 602-8585 (JP)
(72) Inventor: MATSUI, Hiroakira, Kyoto-shi, Kyoto 602-8585 (JP); SEIWA, Takaaki, Kyoto-shi, Kyoto 602-8585 (JP); INAGI, Dai, Kyoto-shi, Kyoto 602-8585 (JP); UENO, Tomohiro, Kyoto-shi, Kyoto 602-8585 (JP); NAKANO, Yuta, Kyoto-shi, Kyoto 602-8585 (JP); YOSHIHARA, Koki, Kyoto-shi, Kyoto 602-8585 (JP); ONO, Takuya, Kyoto-shi, Kyoto 602-8585 (JP)
(74) Representative: Kilian Kilian & Partner mbB
(86) International application number: PCT/JP2022/046740
(87) International publication number: WO 2023/140005

(57) **Abstract**

An assistance device assists a maintenance work for one or a plurality of substrate processing apparatuses 1. Further, the assistance device acquires deviation degree information. The deviation degree information represents respective degrees of deviation between a plurality of respective processing information pieces and a plurality of actually collected respective processing information pieces. The plurality of respective processing information pieces are predicted based on invariant relationships in regard to a plurality of processing information pieces representing operations or states related to a process for a substrate in each of one or a plurality of substrate processing apparatuses and a plurality of processing information pieces that are actually collected from the substrate processing apparatus. Further, the assistance device generates assistance information related to a maintenance work for the substrate processing apparatus based on the deviation degree information.

## Description

### [Technical Field]

The present invention relates to an assistance device, an assistance method and an assistance program for assisting a maintenance work for one or a plurality of substrate processing apparatuses.

### [Background Art]

A substrate processing apparatus is used to execute various processes on various substrates such as a semiconductor substrate. In the substrate processing apparatus 1, a series of processes is executed on a substrate in accordance with a predetermined processing procedure (processing recipe), for example. In order to prevent an occurrence of a processing defect in a substrate due to an abnormality present in a substrate processing apparatus, a data processing system for making determination in regard to an abnormality present in a substrate processing apparatus has been proposed (see Patent Document 1, for example).

In the data processing system, a plurality of physical quantities related to a substrate processing apparatus are measured during a process for a substrate, and these measurement results are arranged in a chronological order, so that a plurality of time-series data pieces are generated. The plurality of time-series data pieces include data of the physical quantities such as a flow rate of a processing liquid discharged from a nozzle and a pressure in a chamber, for example. Each time-series data piece is compared with predetermined reference data, so that an evaluation value is calculated. It is determined whether an abnormality is present in the time-series data based on the calculated evaluation value.

### [Patent Document 1]JP 2020-47847 A

### [Summary of Invention]

### [Technical Problem]

In the following description, a person who performs a maintenance work for a substrate processing apparatus is referred to as a maintenance worker. The maintenance worker for the substrate processing apparatus can recognize whether an abnormality has occurred in the substrate processing apparatus based on an abnormality determination result provided by the above-mentioned data processing system. However, even though being able to recognize an occurrence of an abnormality in the substrate processing apparatus, an unskilled maintenance worker might not be able to specify the cause of the abnormality. Alternatively, even though being able to specify the cause of an occurrence of an abnormality, an unskilled maintenance worker might not be able to identify the content of appropriate work for resolution of the occurring abnormality. In these cases, the maintenance worker requires a long period of time to perform the maintenance work on the substrate processing apparatus.

An object of the present invention is to provide an assistance device, an assistance method and an assistance program that enable a maintenance worker to perform an appropriate maintenance work on a substrate processing apparatus in a short period of time regardless of a degree of skill.

### [Solution to Problem]

(1) An assistance device according to one aspect of the present invention that assists a maintenance work for a substrate processing apparatus, includes a deviation degree acquirer that acquires deviation degree information representing respective degrees of deviation between a plurality of respective processing information pieces and a plurality of actually collected respective processing information pieces, the plurality of respective processing information pieces being predicted based on invariant relationships in regard to a plurality of processing information pieces representing operations or states related to a process for a substrate in the substrate processing apparatus and a plurality of processing information pieces that are actually collected from the substrate processing apparatus, and an assistance information generator that generates assistance information related to a maintenance work for the substrate processing apparatus based on the deviation degree information.
   With the assistance device, assistance information based on deviation information is generated. Thus, a maintenance worker who performs the maintenance work on the substrate processing apparatus can perform an appropriate maintenance work on the substrate processing apparatus in a short period of time based on the generated assistance information regardless of a degree of skill.
(2) The substrate processing apparatus may include a plurality of components related to the plurality of processing information pieces, the assistance device may further include a subject determiner that determines one or a plurality of components subject to the maintenance work from among the plurality of components based on the deviation degree information as one or a plurality of maintenance subject components, and the assistance information may include information representing the one or plurality of maintenance subject components determined by the subject determiner.
   In this case, the maintenance worker can recognize one or a plurality of maintenance subject components in a short period of time based on the generated assistance information.
(3) A plurality of combinations each of which includes two different processing information pieces may be defined in regard to the plurality of processing information pieces, each combination may include a first processing information piece and a second information processing piece, in regard to each combination, the first processing information piece that is predicted based on the second processing information piece actually collected from the substrate processing apparatus and the invariant relationship may be generated as a first prediction processing information piece, and a degree of deviation between the generated first prediction processing information piece and the first processing information piece actually collected from the substrate processing apparatus may be calculated as a first deviation degree, in regard to each combination, the second processing information piece that is predicted based on the first processing information piece actually collected from the substrate processing apparatus and the invariant relationship may be generated as a second prediction processing information piece, and a degree of deviation between the generated second prediction processing information piece and the second processing information piece actually collected from the substrate processing apparatus may be calculated as a second deviation degree, the deviation degree acquirer may acquire a plurality of first deviation degrees that are respectively calculated in regard to the plurality of combinations, and a plurality of second deviation degrees that are respectively calculated in regard to the plurality of combinations as the deviation degree information, and the subject determiner may extract one or a plurality of combinations having the first deviation degrees exceeding a predetermined first threshold value, and one or a plurality of combinations having the second deviation degrees exceeding a predetermined second threshold value, and in regard to each of the one or plurality of extracted combinations, determines one or a plurality of components commonly related to a first processing information piece and a second processing information piece included in the combination as the one or plurality of maintenance subject components. In this case, the one or plurality of maintenance subject components are appropriately determined based on the plurality of actually collected processing information pieces.
(4) The assistance device may further include a necessity calculator that, in regard to each of the one or plurality of maintenance subject components determined by the subject determiner, acquires information related to a state of the maintenance subject component that changes over time as temporal component information, and calculates a necessity value indicating a degree of necessity of the maintenance work for the maintenance subject component based on the acquired temporal component information, wherein the assistance information generator, in regard to each of the one or plurality of maintenance subject components determined by the subject determiner, may determine which one of a plurality of predetermined necessity levels the necessity value calculated by the necessity value calculator belongs to, and may cause the assist information to include information about a predetermined maintenance work for the maintenance subject component according to the determined necessity level.
   In this case, the maintenance worker can recognize an appropriate maintenance work corresponding to the state of each of the one or plurality of maintenance subject components in a short period of time based on the generated assistance information.
(5) Each substrate processing apparatus may be a substrate cleaning device that cleans a substrate using a cleaning liquid, and the plurality of processing information pieces may include at least one of an amount of cleaning liquid supplied to a substrate, a temperature of the cleaning liquid supplied to the substrate and a concentration of the cleaning liquid supplied to the substrate. In this case, assistance information corresponding to the substrate cleaning device is generated.
(6) An assistance method of assisting a maintenance work for a substrate processing apparatus includes acquiring deviation degree information representing respective degrees of deviation between a plurality of respective processing information pieces and a plurality of actually collected respective processing information pieces, the plurality of respective processing information pieces being predicted based on invariant relationships in regard to a plurality of processing information pieces representing operations or states related to a process for a substrate in the substrate processing apparatus and a plurality of processing information pieces that are actually collected from the substrate processing apparatus, and generating assistance information related to a maintenance work for the substrate processing apparatus based on the deviation degree information.
   With the assistance method, assistance information based on deviation information is generated. Thus, the maintenance worker who performs a maintenance work on the substrate processing apparatus can perform an appropriate maintenance work on the substrate processing apparatus in a short period of time based on the generated assistance information regardless of a degree of skill.
(7) An assistance program according to yet another aspect of the present invention that causes a computer to execute an assistance process of assisting a maintenance work for a substrate processing apparatus, wherein the assistance process includes the processes of acquiring deviation degree information representing respective degrees of deviation between a plurality of respective processing information pieces and a plurality of actually collected respective processing information pieces, the plurality of respective processing information pieces being predicted based on invariant relationships in regard to a plurality of processing information pieces representing operations or states related to a process for a substrate in the substrate processing apparatus and a plurality of processing information pieces that are actually collected from the substrate processing apparatus, and generating assistance information related to a maintenance work for the substrate processing apparatus based on the deviation degree information.

With the assistance program, assistance information based on deviation degree information is generated. Thus, the maintenance worker who performs a maintenance work on the substrate processing apparatus can perform an appropriate maintenance work on the substrate processing apparatus in a short period of time based on the generated assistance information regardless of a degree of skill.

### [Advantageous Effects of Invention]

With the present invention, a maintenance worker can perform an appropriate maintenance work on a substrate processing apparatus in a short period of time regardless of a degree of skill.

### [Brief Description of the Drawings]

[FIG. 1] Fig. 1 is a diagram for explaining the overall configuration of a substrate processing apparatus management system according to one embodiment of the present invention.
[FIG. 2] Fig. 2 is a diagram for explaining the specific example of calculation of deviation degrees.
[FIG. 3] Fig. 3 is a diagram for explaining the specific example of calculation of an abnormality score.
[FIG. 4] Fig. 4 is a diagram showing one example of data-related component information.
[FIG. 5] Fig. 5 is a diagram showing one example of temporal component information.
[FIG. 6] Fig. 6 is a block diagram for explaining the functional configurations of an information analysis device and an assistance device.
[FIG. 7] Fig. 7 is a flowchart showing one example of a process executed in a control device of Fig. 6 in regard to determination of an abnormality present in a substrate processing apparatus.
[FIG. 8] Fig. 8 is a flowchart showing one example of a process executed in an information analysis device in order to determine an abnormality present in the substrate processing apparatus of Fig. 6.
[FIG. 9] Fig. 9 is a flowchart showing one example of a process executed by the assistance device in order to assist a maintenance work for the substrate processing apparatus of Fig. 6.
[FIG. 10] Fig. 10 is a flowchart showing one example of a process executed by the assistance device in order to assist a maintenance work for the substrate processing apparatus of Fig. 6.

### [Description of Embodiments]

An assistance device, an assistance method and an assistance program according to one embodiment of the present invention will be described below with reference to the drawings. In the following description, a substrate refers to a semiconductor substrate, a substrate for an FPD (Flat Panel Display) such as a liquid crystal display device or an organic EL (Electro Luminescence) display device, a substrate for an optical disc, a substrate for a magnetic disc, a substrate for a magneto-optical disc, a substrate for a photomask, a ceramic substrate, a substrate for a solar battery, or the like. In the following description, a person who performs a maintenance work for a substrate processing apparatus is referred to as a maintenance worker.

### 1. Overall Configuration of Substrate Processing Apparatus Management System

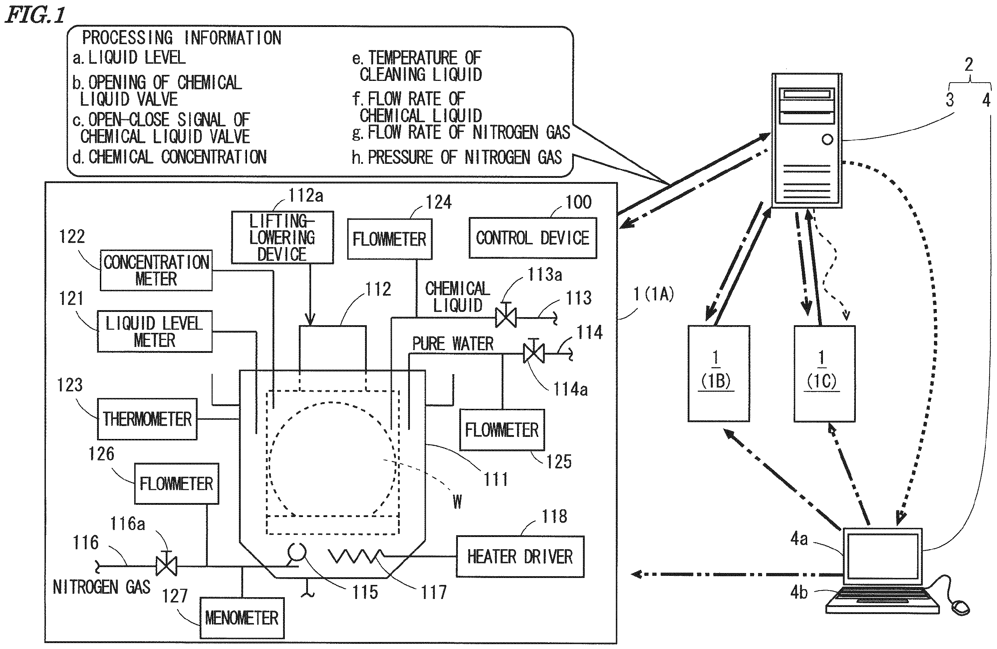

First, the overall configuration of a substrate processing apparatus management system including an assistance device according to the present embodiment will be described. Fig. 1 is a diagram for explaining the overall configuration of the substrate processing apparatus management system according to the one embodiment of the present invention. As shown in Fig. 1, the substrate processing apparatus management system 2 mainly includes an information analysis device 3 and the assistance device 4, and is used to manage one or a plurality (three in the example of Fig. 1) of substrate processing apparatuses 1. In the following description, in a case in which the three substrate processing apparatuses 1 shown in Fig. 1 are distinguished from one another, the three substrate processing apparatuses 1 are respectively referred to as the substrate processing apparatuses 1A, 1B, 1C. In the present embodiment, the substrate processing apparatuses 1Ato 1C have the same configuration.

The assistance device 4 according to the present embodiment is used to assist the maintenance work for each substrate processing apparatus 1 performed by the maintenance worker. The assistance device 4 is connected to each of the one or plurality of substrate processing apparatus 1 and the information analysis device 3 by a wired or wireless communication line or a wired or wireless communication network. For example, the assistance device 4 is connected to each of the one or plurality of substrate processing apparatuses 1 and the information analysis device 3 by a communication network such as the Internet. In the present embodiment, the assistance device 4 is connected to each of the one or plurality of substrate processing apparatuses 1 and the information analysis device 3 by a wired or wireless LAN.

### 2. One Example of Configuration of Substrate Processing Apparatus 1A

As shown in Fig. 1, the substrate processing apparatus 1A is a batch-type substrate cleaning device, and includes a control device 100, a processing tank 111, a substrate holder 112, a lifting-lowering device 112a, a bubbler pipe 115, a heater 117 and a heater driver 118. In the substrate processing apparatus 1A, a display device, a speech output device and an operation unit (not shown) are provided in addition to the plurality of above-mentioned constituent elements.

The substrate holder 112 is configured to be capable of holding a plurality of substrates W. The processing tank 111 is configured to be capable of accommodating the plurality of substrates W held by the substrate holder 112. A cleaning liquid for cleaning the substrate W is stored in the processing tank 111.

The lifting-lowering device 112a supports the substrate holder 112 to be movable in an upward-and-downward direction and moves the substrate holder 112 in the upward-and-downward direction with the control of the control device 100. Thus, the lifting-lowering device 112a can immerse the plurality of substrates W held by the substrate holder 112 in the cleaning liquid stored in the processing tank 111, and can pull up the plurality of substrates W immersed in the cleaning liquid from the processing tank 111. The plurality of substrates W are cleaned by being immersed in the cleaning liquid. Further, in the lifting-lowering device 112a, a motor (not shown) as a power source for moving the substrate holder 112 in the upward-and-downward direction is provided.

A chemical liquid pipe 113 and a pure water pipe 114 are connected to the processing tank 111. A chemical liquid valve 113a and a flowmeter 124 are provided in the chemical liquid pipe 113. The chemical liquid valve 113a is a control valve the opening of which is adjustable by the control of the control device 100.

The chemical liquid pipe 113 guides a chemical liquid supplied from a chemical liquid supply system (not shown) to the processing tank 111 when the chemical liquid valve 113a is opened. The flow rate (a supply amount per unit time) of the chemical liquid supplied to the processing tank 111 through the chemical liquid pipe 113 changes in accordance with an opening (a degree of opening) of the chemical liquid valve 113a. As the chemical liquid, BHF (Buffered Hydrofluoric Acid), DHF (Dilute Hydrofluoric Acid), hydrofluoric acid, hydrochloric acid, sulfuric acid, nitric acid, phosphoric acid, acetic acid, oxalic acid, ammonia, or the like is used. The flowmeter 124 detects a flow rate of the chemical liquid in the portion farther downstream than the chemical liquid valve 113a in the chemical liquid pipe 113, and provides a detection result to the control device 100.

A pure water valve 114a and a flowmeter 125 are provided in the pure water pipe 114. The pure water valve 114a is a control valve the opening of which is adjustable by the control of the control device 100.

The pure water pipe 114 guides a pure water supplied from a pure water supply system (not shown) to the processing tank 111 when the pure water valve 114a is opened. The flow rate (supply amount per unit time) of the pure water supplied to the processing tank 111 through the pure water pipe 114 changes in accordance with an opening (a degree of opening) of the pure water valve 114a. The flowmeter 125 detects a flow rate of the pure water in the portion farther downstream than the pure water valve 114a in the pure water pipe 114, and provides a detection result to the control device 100.

The bubbler pipe 115 is fixed to a portion inside of the processing tank 111 and in the vicinity of the lower end portion of the processing tank 101 by a bubbler fixture (not shown). A gas pipe 116 is connected to the bubbler pipe 115. In the gas pipe 116, a gas valve 116a, a flowmeter 126 and a manometer 127 are provided. The gas valve 116a is a control valve the opening of which is adjustable by the control of the control device 100.

The gas pipe 116 guides a nitrogen gas supplied from a gas supply system (not shown) to the bubbler pipe 115 in the processing tank 111 when the gas valve 116a is opened. The flow rate (supply amount per unit time) of the nitrogen gas supplied to the bubbler pipe 115 through the gas pipe 116 changes in accordance with an opening (a degree of opening) of the gas valve 116a.

The flowmeter 126 detects a flow rate of the nitrogen gas in the portion farther downstream than the gas valve 116a in the gas pipe 116, and provides a detection result to the control device 100. In this case, the control device 100 adjusts the opening of the gas valve 116a based on the flow rate provided by the flowmeter 126 such that the nitrogen gas is supplied to the bubbler pipe 115 at a predetermined flow rate. The manometer 127 detects an inner pressure in the portion farther downstream than the gas valve 116a in the gas pipe 116, and provides a detection result to the control device 100.

The openings of the chemical liquid valve 113a and the pure water valve 114a are adjusted, so that the chemical liquid and the pure water are supplied into the processing tank 111 at a predetermined ratio. In this state, the gas valve 116a is further opened. Thus, the nitrogen gas is supplied to the bubbler pipe 115, and a large amount of bubbles are generated in the bubbler pipe 115. The generated bubbles are lifted in the processing tank 111. Therefore, the chemical liquid and the pure water supplied into the processing tank 111 are mixed, and the cleaning liquid is generated. Instead of the nitrogen gas, another inert gas such as an argon gas may be supplied to the bubbler pipe 115.

The heater 117 is further provided in a portion inside of the processing tank 111 and in the vicinity of the lower end portion of the processing tank 111. The heater driver 118 drives the heater 117 by supplying electric power to the heater 117. An amount of power supplied from the heater driver 118 to the heater 117 is controlled by the control device 100.

Further, a drain pipe is connected to a bottom portion of the processing tank 111. A valve (not shown) is provided in the drain pipe. The valve provided in the drain pipe is opened, so that the cleaning liquid in the processing tank 111 is discharged to the outside of the substrate processing apparatus 1A.

In the processing tank 111, a liquid level meter 121, a concentration meter 122 and a thermometer 123, as a plurality of detectors for detecting the states of the cleaning liquid stored in the processing tank 111, are provided.

The liquid level meter 121 detects a height of liquid surface (liquid level) of the cleaning liquid stored in the processing tank 111 and provides a detection result to the control device 100. The concentration meter 122 detects a concentration of the cleaning liquid (chemical concentration) stored in the processing tank 111 and provides a detection result to the control device 100. The thermometer 123 detects a temperature of the cleaning liquid stored in the processing tank 111 and provides a detection result to the control device 100.

The control device 100 includes a CPU (Central Processing Unit) and a memory, for example, and controls an operation of the lifting-lowering device 112a, an operation of the heater driver 118, openings of the chemical liquid valve 113a, the pure water valve 114a and the gas valve 116a, and the like. The memory of the control device 100 stores a substrate processing program for execution of a cleaning process for the substrate W executed by the substrate processing apparatus 1A.

Further, based on the detection results of the flowmeters 124, 125, 126, the detection result of the liquid level meter 121 and the detection result of the concentration meter 122, the control device 100 adjusts the openings of the chemical liquid valve 113a, the pure water valve 114a, the gas valve 116a and the drain pipe (not shown). Thus, in a state in which the cleaning liquid having a predetermined chemical concentration is stored in the processing tank 111, the liquid level of the cleaning liquid is maintained at a predetermined height. Further, based on the temperature provided by the thermometer 123, the control device 100 controls the heater driver 118 such that the cleaning liquid stored in the processing tank 111 is maintained at a predetermined temperature.

Further, the control device 100 has an emergency shutdown function for stopping an operation of the substrate processing apparatus 1A in a case in which a person enters a predetermined space inside of the substrate processing apparatus 1A or a predetermined detector (the concentration meter 122, for example) provided in the substrate processing apparatus 1A is not functioning.

### 3. Processing Information

In each substrate processing apparatus 1, as information for detection of an abnormality present in the substrate processing apparatus 1, a plurality of processing information pieces representing the operations or states related to a process for the substrate W are defined. As indicated by the thick solid arrows in Fig. 1, these processing information pieces are transmitted from the control device 100 of each substrate processing apparatus 1 to the information analysis device 3 of the substrate processing apparatus management system 2 in a predetermined period.

As shown in the balloon of Fig. 1, the processing information pieces transmitted from the substrate processing apparatus 1 to the information analysis device 3 include "a. LIQUID LEVEL," "b. OPENING OF CHEMICAL LIQUID VALVE," "c. OPEN-CLOSE SIGNAL OF CHEMICAL LIQUID VALVE," "d. CHEMICAL CONCENTRATION," "e. TEMPERATURE OF CLEANING LIQUID," "f. FLOW RATE OF CHEMICAL LIQUID," "g. FLOW RATE OF NITROGEN GAS" AND "h. PRESSURE OF NITROGEN GAS."

"a. LIQUID LEVEL" indicates a liquid level of a cleaning liquid in the processing tank 111 detected by the liquid level meter 121. "b. OPENING OF CHEMICAL LIQUID VALVE" indicates an opening of the chemical liquid valve 113a provided in the chemical liquid pipe 113. "c. OPEN-CLOSE SIGNAL OF CHEMICAL LIQUID VALVE" is a signal that is provided from the control device 100 to the chemical liquid valve 113a and provides an instruction for opening or closing the chemical liquid valve 113a.

"d. CHEMICAL CONCENTRATION" indicates a chemical concentration of a cleaning liquid in the processing tank 111 detected by the concentration meter 122. "e. TEMPERATURE OF CLEANING LIQUID" indicates a temperature of a cleaning liquid in the processing tank 111 detected by the thermometer 123. "f. FLOW RATE OF CHEMICAL LIQUID" indicates a flow rate of a chemical liquid flowing through the chemical liquid pipe 113 detected by the flowmeter 124.

"g. FLOW RATE OF NITROGEN GAS" indicates a flow rate of a nitrogen gas flowing through the gas pipe 116 detected by the flowmeter 126. "h. PRESSURE OF NITROGEN GAS" indicates a pressure of a nitrogen gas in the gas pipe 116 detected by the manometer 127.

### 4. Detection of Abnormality in Substrate Processing Apparatus 1 by Information Analysis Device 3

The information analysis device 3 of Fig. 1 is a server, for example, and includes a CPU and a memory. The information analysis device 3 collects a plurality of processing information pieces transmitted from each substrate processing apparatus 1. In the information analysis device 3, in regard to the plurality of processing information pieces transmitted from each substrate processing apparatus 1 to the information analysis device 3, a plurality of combinations each combination of which includes two different processing information pieces are predetermined. A predetermined invariant relationship (hereinafter referred to as an invariant relationship) between two processing information pieces that form each combination is maintained.

Here, it is assumed that an inappropriate substrate process is executed because a substrate process is executed with an abnormality present in the substrate processing apparatus 1. In this case, at least the relationship between two processing information pieces forming one combination out of the plurality of combinations deviates from the invariant relationship.

The information analysis device 3 calculates a plurality of deviation degrees in regard to a plurality of processing information pieces. A deviation degree indicates a degree of deviation from the predetermined invariant relationship between two processing information pieces to the relationship between two actually collected processing information pieces in regard to the two processing information pieces. Further, based on the plurality of calculated deviation degrees, the information analysis device 3 calculates an abnormality degree of the substrate processing apparatus 1 as an abnormality score. The specific example of a method of calculating an abnormality score will be described below.

As indicated by the thick one-dot and dash arrows in Fig. 1, the information analysis device 3 transmits an abnormality score calculated in regard to each substrate processing apparatus 1 to the substrate processing apparatus 1. An abnormality score is transmitted each time the abnormality score is calculated in the information analysis device 3. At this time, each substrate processing apparatus 1 stores an abnormality score transmitted from the information analysis device 3.

Further, in regard to each substrate processing apparatus 1, the information analysis device 3 determines whether an abnormality score exceeds a predetermined abnormality determination threshold value. As indicated by the wavy dotted arrow in Fig. 1, in a case in which an abnormality score exceeds the abnormality determination threshold value, the information analysis device 3 transmits a warning to the substrate processing apparatus 1 corresponding to the abnormality score. In the example of Fig. 1, the information analysis device 3 transmits a warning only to the substrate processing apparatus 1C out of the substrate processing apparatuses 1A to 1C. At this time, the substrate processing apparatus 1C that has received the warning outputs a warning.

In the present embodiment, an abnormality that does not require maintenance by the maintenance worker has a lower abnormality score (degree of abnormality), and an abnormality that requires maintenance by the maintenance worker has a higher abnormality score (degree of abnormality).

In case of a low abnormality score, it includes a case in which, it is predicted, based on the invariant relationships respectively corresponding to the plurality of above-mentioned combinations, that all of a plurality of processing conditions are in a normal range.

On the other hand, in case of a high abnormality score, it includes a case in which the actual temporal change of "d. CHEMICAL CONCENTRATION" is significantly larger than the temporal change of "d. CHEMICAL CONCENTRATION" that is predicted based on the temporal change of "f. FLOW RATE OF CHEMICAL LIQUID," for example. When this state continues, it causes a processing defect in the substrate W, generation of a harmful gas, and damage to a component of the substrate processing apparatus 1, for example, due to the inability to adjust the chemical concentration of a cleaning liquid.

Further, in case of a high abnormality score, it includes a case in which the actual value of "a. LIQUID LEVEL" is significantly different from the value of "a. LIQUID LEVEL" that is predicted based on the temporal change of "g. FLOW RATE OF NITROGEN GAS," for example. When this state continues, it causes a processing defect in the substrate W, generation of a harmful gas, and damage to a component of the substrate processing apparatus 1, for example, due to the inability to ensure the immersion of the substrate W in a cleaning liquid.

### 5. Specific Example of Method of Calculating Abnormality Score

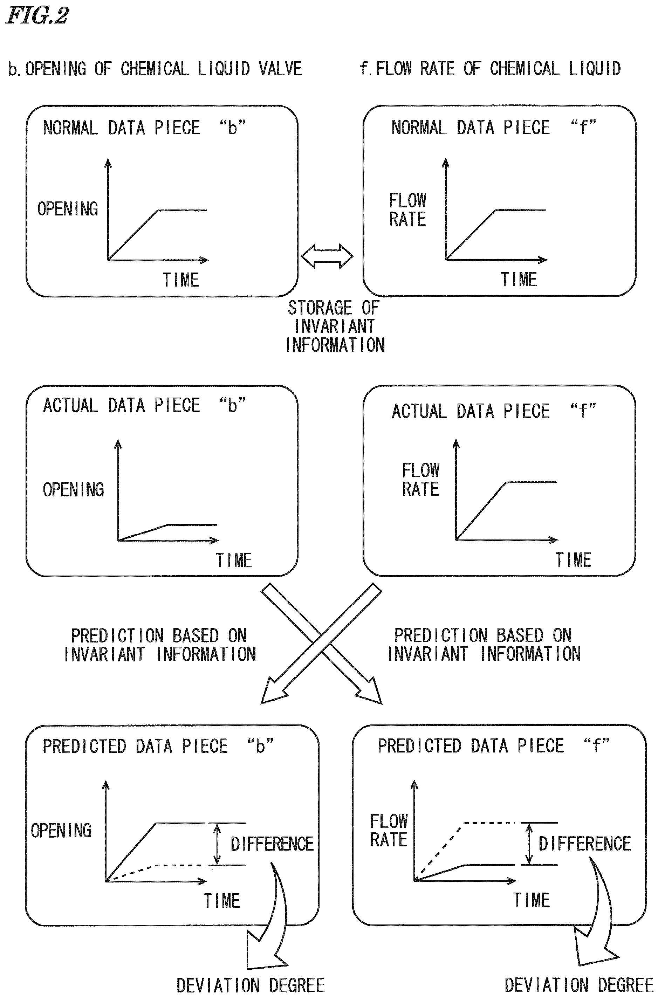

As described above, in the information analysis device 3, the plurality of combinations each of which includes two different processing information pieces are defined. In order to calculate an abnormality score, a deviation degree is calculated in regard to each combination. Fig. 2 is a diagram for explaining the specific example of calculation of a deviation degree. Here, the example of calculation of a deviation degree corresponding to the combination of "b. OPENING OF CHEMICAL LIQUID VALVE" and "f. FLOW RATE OF CHEMICAL LIQUID" of Fig. 1 is described. In the following description, the data of "b. OPENING OF CHEMICAL LIQUID VALVE" is suitably referred to as a data piece "b" and the data of "f. FLOW RATE OF CHEMICAL LIQUID" is suitably referred to as a data piece "f."

In order to calculate a deviation degree, the information representing the invariant relationship between "b. OPENING OF CHEMICAL LIQUID VALVE" and "f. FLOW RATE OF CHEMICAL LIQUID" is required. In the following description, the information representing the invariant relationship between two processing information pieces is referred to as invariant information. The invariant information is preferably created by machine learning, for example.

It is assumed that machine learning is performed to obtain the invariant information between "b. OPENING OF CHEMICAL LIQUID VALVE" and "f. FLOW RATE OF CHEMICAL LIQUID." In this case, before a process is actually executed on the substrate W in each substrate processing apparatus 1, a data piece "b" and a data piece "f" obtained when the substrate processing apparatus 1 is ideally operating (normally operating) in accordance with a recipe are provided to the information analysis device 3.

In the upper portion of Fig. 2, one example of the temporal changes of a normal data piece "b" and a normal data piece "f" is shown. In the graph for the data piece "b," the abscissa indicates time, and the ordinate indicates an opening of the chemical liquid valve 113a of Fig. 1. In the graph for the data piece "f," the abscissa indicates time, and the ordinate indicates a flow rate of a chemical liquid in the portion farther downstream than the chemical liquid valve 113a in the chemical liquid pipe 113 of Fig. 1. The abscissa (time axis) is common between the graph for the data piece "b" and the graph for the data piece "f".

According to the two graphs in the upper portion of Fig. 2, it is found that the flow rate of the chemical liquid flowing through the chemical liquid pipe 113 increases at a substantially constant rate as the opening of the chemical liquid valve 113a increases. At this time, the relationship between the normal data piece "b" and the normal data piece "f" represents the invariant relationship. In this manner, in a case in which the substrate processing apparatus 1 operates ideally, the relationship between data pieces in each combination among the plurality of processing information pieces is equal to the invariant relationship. As such, a plurality of normal processing information pieces are input in advance to the information analysis device 3. Thus, the invariant relationship in regard to data pieces in each combination among the plurality of processing information pieces is modeled by machine learning, and invariant information is generated. As a result, the invariant relationship suitable for each substrate processing apparatus 1 is stored in the information analysis device 3.

The invariant information is not limited to the above-mentioned example, and may be generated by simulation or the like in which it is assumed that the substrate processing apparatus 1 is normally operating, or may be determined by an administrator or the like who manages each substrate processing apparatus 1, for example.

In a state where the invariant information is stored in the information analysis device 3, a process is executed on the substrate W in each substrate processing apparatus 1, and an actual data piece "b" and an actual data piece "f" are collected by the information analysis device 3. In the center portion of Fig. 2, one example of the temporal changes of the actually collected data piece "a" and the actually collected data piece "b" is shown by the graphs.

When the actual data piece "b" is collected, the data piece "f" is predicted based on the pre-stored invariant information. Further, when the actual data piece "f" is collected, the data piece "b" is predicted based on the pre-stored invariant information. In the lower portion of Fig. 2, one example of the temporal changes of the data piece "b" and the data piece "f" that are predicted based on the invariant information is shown by the graphs. In the graphs in the lower portion of Fig. 2, a predicted data piece "b" and a predicted data piece "f" are indicated by the solid lines, and the actually collected data piece "b" and the actually collected data piece "f" are indicated by the dotted lines.

In a case in which the substrate processing apparatus 1 is normally operating, the actual data piece "b" and the predicted data piece "b" coincide or substantially coincide with each other. Further, the actual data piece "f" and the predicted data piece "f" coincide or substantially coincide with each other. However, in a case in which an abnormality is present in the substrate processing apparatus 1, the actual data piece "b" and the predicted data piece "b" are likely to deviate from each other. Further, the actual data piece "f" and the predicted data piece "f" are likely to deviate from each other. It is considered that, the larger a degree of abnormality that occurs in the substrate processing apparatus 1, the larger a degree of deviation, and the smaller a degree of abnormality that occurs in the substrate processing apparatus 1, the smaller a degree of deviation.

As such, in the present embodiment, the difference value between the data representing the actually collected processing information piece and the data representing the predicted processing information piece is calculated as a deviation degree. In the example of Fig. 2, the information analysis device 3 calculates the difference value between the actual data piece "b" and the predicted data piece "b" as a deviation degree when calculating a deviation degree at a certain point in time. Further, the score calculator 32 calculates the difference value between the actual data piece "b" and the predicted data piece "b" as a deviation degree.

In the following description, the processing information pieces for "a. LIQUID LEVEL," "b. OPENING OF CHEMICAL LIQUID VALVE," "c. OPEN-CLOSE SIGNAL OF CHEMICAL VALVE," "d. CHEMICAL CONCENTRATION," "e. TEMPERATURE OF CLEANING LIQUID," "f. FLOW RATE OF CHEMICAL LIQUID," "g. FLOW RATE OF NITROGEN GAS," and "h. PRESSURE OF NITROGEN GAS" are referred to as processing information pieces "a," "b," "c," "d," "e," "f," "g" and "h," respectively.

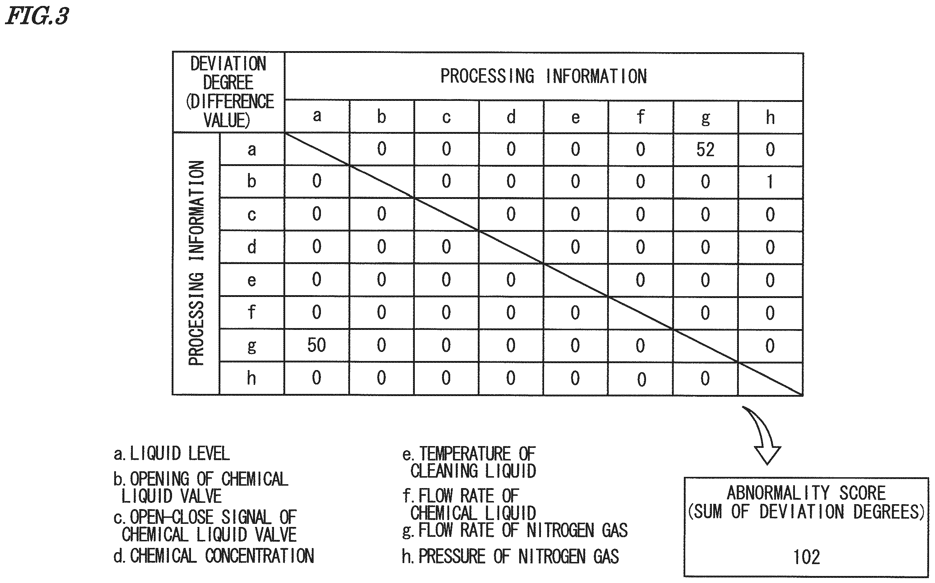

Fig. 3 is a diagram for explaining the specific example of calculation of an abnormality score. The information analysis device 3 calculates the above-mentioned deviation degrees in regard to all combinations in the plurality of processing information pieces. Each of the plurality of values arranged in the row at the right of each of the processing information pieces "a" to "h" in the left column of Fig. 3 represents the deviation degree between a processing information piece predicted based on each of the processing information pieces "a" to "h" in the upper row, and an actually acquired processing information piece. Each of the plurality of values arranged in the column below each of the processing information pieces "a" to "h" in the upper row of Fig. 3 represents the deviation degree between a processing information piece predicted based on each of the processing information pieces "a" to "h" in the left column, and an actually acquired processing information piece.

For example, the value "52" at the intersection of the row for the processing information piece "a" in the left column and the column for the processing information piece "g" in the upper row represents the deviation degree between the processing information piece "a" that is predicted based on the processing information piece "g" and the actually acquired processing information piece "a." Further, the value "50" at the intersection of the row for the processing information piece "g" in the left column and the column for the processing information piece "a" in the upper row represents the deviation degree between the processing information piece "g" that is predicted based on the processing information piece "a" and the actually acquired processing information piece "g."

Fig. 3 shows the plurality of deviation degrees calculated in regard to all combinations of the plurality of processing information pieces. When all of the deviation degrees are calculated, the information analysis device 3 calculates the sum of the plurality of calculated deviation degrees as an abnormality score. In the example of Fig. 3, the abnormality score is 102.

### 6. Assistance of Maintenance Work for Substrate Processing Apparatus 1 in Assistance Device 4

The assistance device 4 of Fig. 1 is a personal computer, for example, and includes a CPU and a memory. Further, the assistance device 4 includes a display 4a and an operation unit 4b. Each of the plurality of maintenance workers who are respectively in charge of the plurality of substrate processing apparatuses 1 can recognize a degree of abnormality in regard to the substrate processing apparatus 1, which each maintenance worker is in charge of, by checking an abnormality score transmitted from the information analysis device 3. Further, each maintenance worker can recognize that a serious abnormality has occurred in the substrate processing apparatus 1, which each maintenance worker is in charge of, when the substrate processing apparatus 1 receives a warning from the information analysis device 3.

However, even though being able to recognize the degree of an abnormality present in the substrate processing apparatus 1, the maintenance worker might not be able to specify the cause of the abnormality in the substrate processing apparatus 1. Alternatively, even though being able to specify the cause of an occurrence of an abnormality, an unskilled maintenance worker might not be able to identify the content of appropriate work for resolution of the occurring abnormality. In these cases, each maintenance worker requires a long period of time to perform the maintenance work for the substrate processing apparatus.

As such, as indicated by the thick dotted arrow in Fig. 1, the information analysis device 3 according to the present embodiment transmits each of the plurality of calculated deviations degrees calculated in regard to each substrate processing apparatus 1 to the assistance device 4 together with two processing information pieces corresponding to the deviation degree. Further, in regard to each substrate processing apparatus 1, the assistance device 4 generates assistance information for assisting the maintenance work for the substrate processing apparatus 1 based on the plurality of deviation degrees received from the information analysis device 3, data-related component information, described below, and temporal component information, described below. Further, as indicated by the thick two-dots and dash arrows in Fig. 1, the assistance device 4 supplies the generated assistance information to the substrate processing apparatus 1 corresponding to the assistance information. The specific examples of the assistance information and a method of generating the assistance information will be described.

The memory of the assistance device 4 stores the data-related component information and the temporal component information in advance in order to generate the above-mentioned assistance information. The data-related component information is the information representing each of a plurality of processing information pieces collected by the information analysis device 3 and one or a plurality of components related to the processing information piece. The data-related component information is defined in advance by the maintenance worker for one substrate processing apparatus 1, an administrator who manages one substrate processing apparatus 1, or the like, before the substrate process is executed in the one substrate processing apparatus 1, for example. Specifically, the data-related component information is generated and updated when the maintenance worker, the administrator or the like operates the operation unit of the substrate processing apparatus 1 or the operation unit 4b of the assistance device 4.

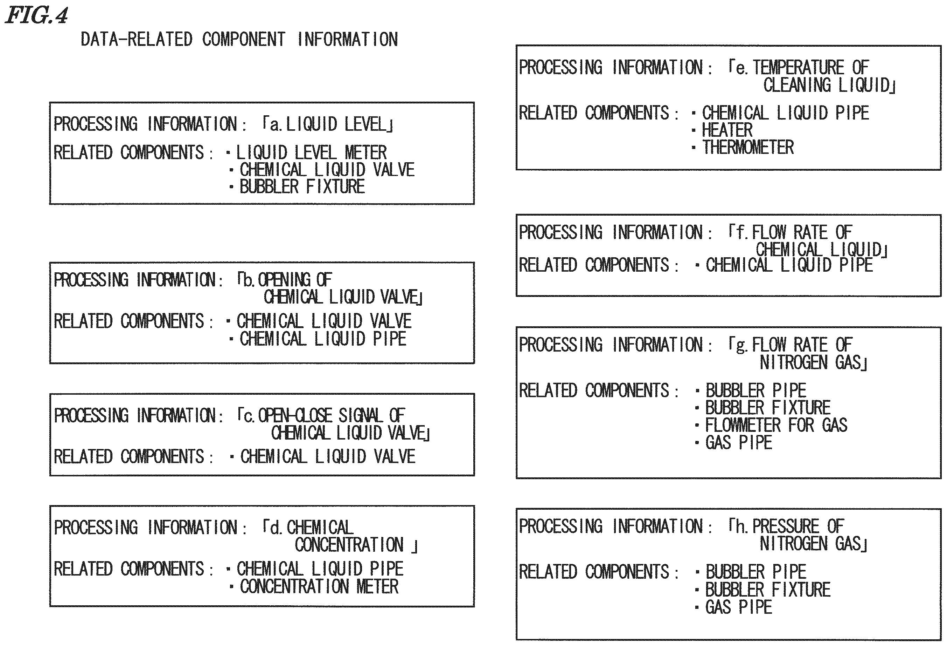

Fig. 4 is a diagram showing one example of the data-related component information. According to the data-related component information of Fig. 4, as the components related to the processing information piece "a," the liquid level meter 121, the chemical liquid valve 113a and the bubbler fixture are shown. As the components related to the processing information piece "b," the chemical liquid valve 113a and the chemical liquid pipe 113 are shown. As the components related to the processing information piece "c," the chemical liquid valve 113a is shown.

Further, as the components related to the processing information piece "d," the chemical liquid pipe 113 and the concentration meter 122 are shown. As the components related to the processing information piece "e," the chemical liquid pipe 113, the heater 117 and the thermometer 123 are shown. As the component related to the processing information piece "f," the chemical liquid pipe 113 is shown.

Further, as the components related to the processing information piece "g," the bubbler pipe 115, the bubbler fixture, the flowmeter 126 for gas and the gas pipe 116 are shown. As the components related to the processing information piece "h," the bubbler pipe 115, the bubbler fixture and the gas pipe 116 are shown.

The temporal component information is the information related to a deterioration state that changes over time in regard to each of the plurality of components related to at least part of the plurality of processing information pieces in the data-related component information. In the assistance device 4, the temporal component information is updated to the latest state in a predetermined period.

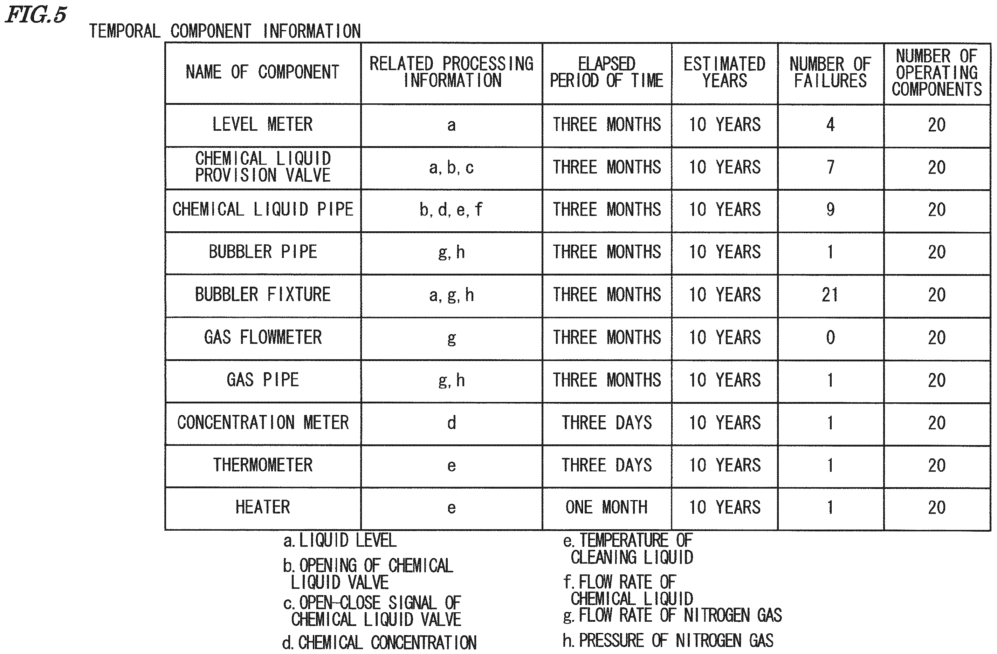

Fig. 5 is a diagram showing one example of the temporal component information. In regard to each of the plurality of components listed in the data-related component information of Fig. 4, the temporal component information of Fig. 5 includes "RELATED PROCESSING INFORMATION," "ELAPSED PERIOD OF TIME," "ESTIMATED YEARS," "NUMBER OF FAILURES," and "NUMBER OF OPERATING COMPONENTS" as information related to the deterioration state of the component.

The "RELATED PROCESSING INFORMATION" represents processing information related to each component, and the relationship between the component and the processing information related to the component is equal to the relationship between each processing information and the component represented by the data-related component information of Fig. 4. "ELAPSED PERIOD OF TIME" is the information representing an elapsed period of time since each component is attached to the substrate processing apparatus 1. "ESTIMATED YEARS" is the information representing the number of estimated years in the service life for each component. "NUMBER OF FAILURES" is the information, in regard to each of the plurality of components, representing the number of failures that have occurred in a component having the same type (same model) as the type of the component in a period from the start of use of the component having the same type (same model) as the component to a current point in time. "NUMBER OF OPERATING COMPONENTS" is the information, in regard to each of the plurality of components, representing the number of all components that have the same type (same model) as the type of the component and are currently operating.

The specific example of generation of assistance information will be described. Here, in the assistance device 4 according to the present embodiment, one or a plurality of deviation-degree threshold values which are commonly or individually determined are stored in regard to a plurality of deviation degrees provided by the information analysis device 3. Each deviation-degree threshold value is defined such that it is possible to determine whether an abnormality of a predetermined degree has occurred in a component related to two processing information pieces used for calculation of a corresponding deviation degree.

In regard to each of the plurality of deviation degrees provided by the information analysis device 3, the assistance device 4 determines whether the deviation degree exceeds the deviation-degree threshold value. As such, in a case in which there is a deviation degree exceeding the deviation-degree threshold value, in regard to the combination of two processing information pieces used for calculation of the deviation degree and data-related component information, the assistance device 4 determines the component commonly related to the two processing information pieces as a maintenance subject component.

For example, it is assumed that "40" is defined as the common deviation-degree threshold value in regard to the plurality of deviation degrees of Fig. 3. In this case, the deviation degree "52" in regard to the processing information piece "a" predicted based on the processing information piece "g" and the actually acquired processing information piece "a" exceeds the deviation-degree threshold value "40." The deviation degree "50" in regard to the processing information piece "g" predicted based on the processing information piece "a" and the actually acquired processing information piece "g" also exceeds the deviation-degree threshold value "40." On the other hand, since being "0," none of the other deviation degrees exceed the deviation- degree threshold value "40." Thus, in the example of the plurality of deviations of Fig. 3, based on the data-related component information of Fig. 4, the component "bubbler fixture" that is associated with the processing information piece "a" and associated with the processing information "g" is determined as a maintenance subject component.

Next, in regard to each of one or a plurality of determined maintenance subject components, the assistance device 4 calculates a degree of necessity for the maintenance work as a maintenance necessity value. A maintenance necessity value is calculated based on the temporal component information of a maintenance subject component using the following formula (1), for example.

A maintenance necessity value = ((an elapsed period of time/estimated years) + (the number of failures/the number of operating components)) x weight···(1)

The "weight" in the above-mentioned formula (1) is defined, for each maintenance subject component, in accordance with the type of abnormality that is estimated to occur due to damage or missing of the maintenance subject component. The types of abnormality include "leakage of a chemical liquid," "damage to a substrate," "extension of a processing period of time" and the like. In this case, the "leakage of a chemical liquid" is highly likely to affect health of the maintenance worker for the substrate processing apparatus 1, or the like. Therefore, a high weight ("3," for example) is assigned to a maintenance subject component that may cause "leakage of a chemical liquid" due to damage or missing of the component. On the other hand, the "damage to a substrate" is less likely to affect the health of the maintenance worker for the substrate processing apparatus 1, or the like. Therefore, a medium weight ("2," for example) is assigned to a maintenance subject component that may cause "damage to a substrate" due to damage or missing of the component. On the other hand, the "extension of a processing period of time" does not affect the health of the maintenance worker for the substrate processing apparatus 1, or the like, and is less likely to cause damage to the substrate processing apparatus 1 or a substrate. Therefore, a low weight ("1," for example) is assigned to a maintenance subject component that may cause "extension of a processing period of time" due to damage or missing of the component.

Thereafter, in regard to each of the one or plurality of maintenance subject components, the assistance device 4 generates information including a maintenance work instruction corresponding to the maintenance subject component as assistance information based on a calculated maintenance necessity value and transmits the assistance information to the substrate processing apparatus 1.

Specifically, the assistance device 4 determines, in regard to each of the one or plurality of maintenance subject components, which one of the plurality of predetermined levels (three levels of high, medium and low, for example) the calculated maintenance necessity value belongs to. Such level assignment can be carried out by setting of a plurality of different reference values, for example, in regard to a maintenance necessity value.

When the maintenance subject component is the "liquid level meter 121," and the level of the maintenance necessity value is "high," the assistance device 4 generates assistance information including "a maintenance work instruction for replacement of the liquid level meter 121," for example. Further, in this case, the assistance device 4 may generate assistance information including "work information to be presented to a maintenance worker in regard to the procedure for replacement of the liquid level meter 121," "report information for creation of a report in regard to replacement of the liquid level meter 121," and the like.

Further, when the maintenance subject component is the "liquid level meter 121," and the level of the maintenance necessity value is "medium," the assistance device 4 generates assistance information including "a maintenance work instruction for checking an operation of the liquid level meter 121 in detail," for example. Further, in this case, the assistance device 4 may generate assistance information including "work information to be presented to a maintenance worker in regard to the procedure for checking of an operation of the liquid level meter 121 in detail," "report information for creation of a report in regard to checking of an operation of the liquid level meter 121," and the like.

Further, when the maintenance subject component is the "liquid level meter 121," and the level of the maintenance necessity value is "low," the assistance device 4 generates assistance information including "a maintenance work instruction for simply checking an operation of the liquid level meter 121," for example. Further, in this case, the assistance device 4 may generate assistance information including "work information to be presented to a maintenance worker in regard to the procedure for simply checking of an operation of the liquid level meter 121," and the like.

The assistance information as described above is transmitted from the assistance device 4 to each substrate processing apparatus 1. In this case, in each substrate processing apparatus 1, the assistance information is presented to the maintenance worker by the display device or the speech output device. Thus, the maintenance worker for the substrate processing apparatus 1 can recognize, based on the received assistance information, what maintenance work is to be performed on which component in the substrate processing apparatus 1, easily and in a short period of time.

### 7. One Example of Functional Configurations and Operations of Substrate Processing Apparatus Management System 2

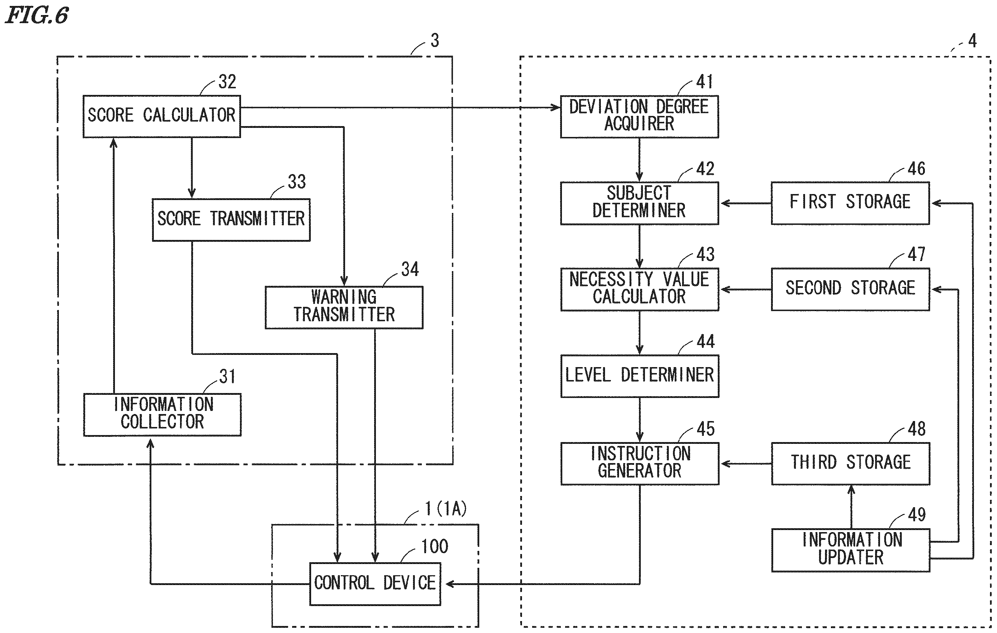

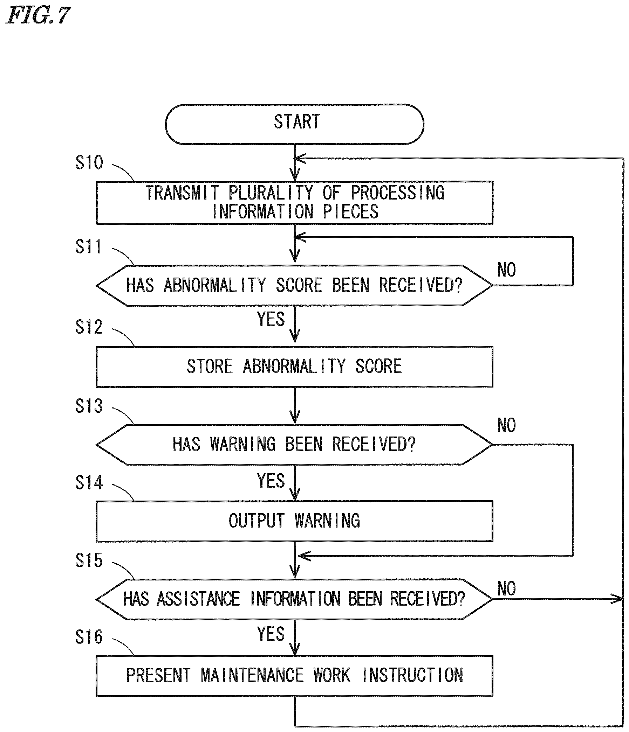

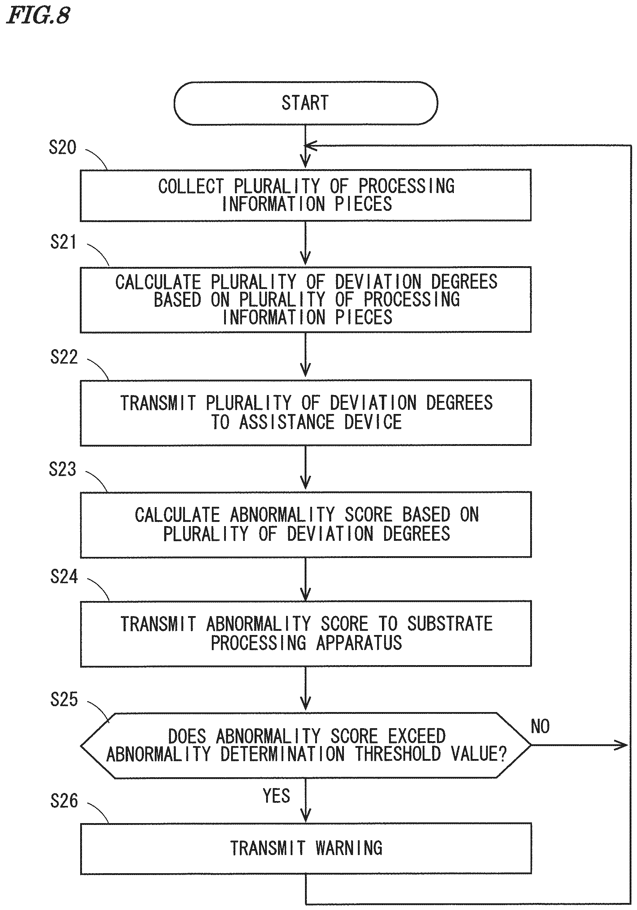

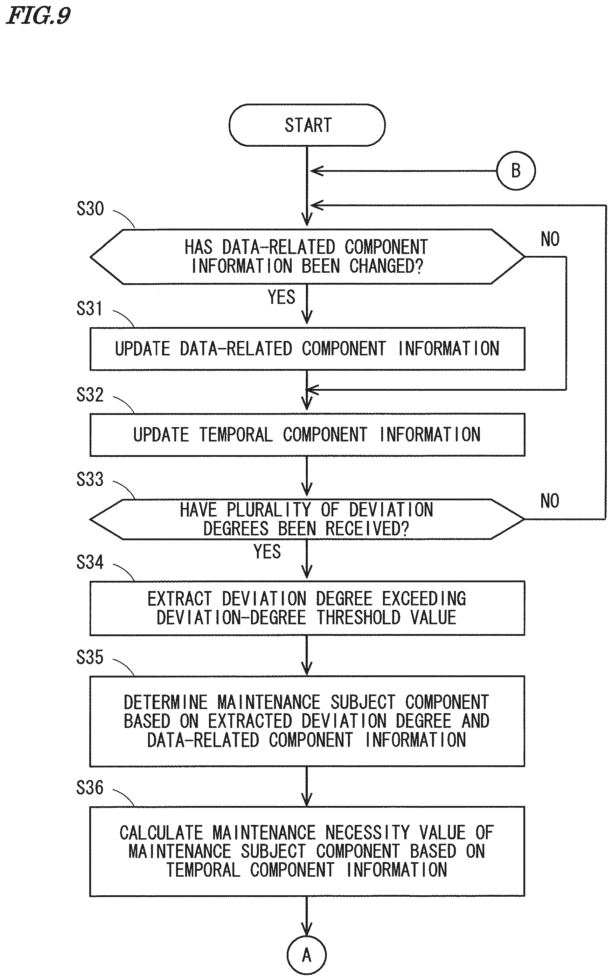

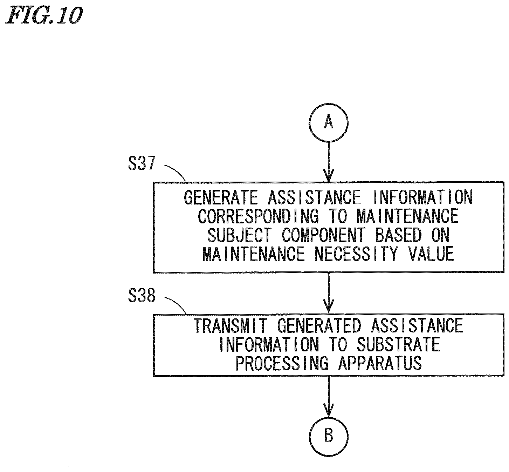

Fig. 6 is a block diagram for explaining the functional configurations of the information analysis device 3 and the assistance device 4 of Fig. 1. Fig. 7 is a flowchart showing one example of a process executed in the control device 100 of Fig. 6 in regard to determination of an abnormality present in the substrate processing apparatus 1. Fig. 8 is a flowchart showing one example of a process executed in the information analysis device 3 in order to determine an abnormality present in the substrate processing apparatus 1 of Fig. 6. Figs. 9 and 10 are flowcharts showing one example of a process executed in the assistance device 4 in order to assist the maintenance work for the substrate processing apparatus 1 of Fig. 6.

In the following description, it is assumed that the substrate processing apparatus management system 2 manages only one substrate processing apparatus 1. Therefore, a series of processes shown in Figs. 8 to 10 is executed only on one substrate processing apparatus 1 of Fig. 6.

As described with reference to Fig. 1, the substrate processing apparatus 1 includes the control device 100. As shown in Fig. 7, the control device 100 transmits a plurality of processing information pieces generated in the substrate processing apparatus 1 during a process for the substrate W to the information analysis device 3 in a predetermined period (step S10). At this time, the control device 100 may store the plurality of processing information pieces in association with points in time at which the plurality of processing information pieces are transmitted.

Next, the control device 100 determines whether an abnormality score has been received from the information analysis device 3 (step S11). In a case in which an abnormality score has not been received, the control device 100 repeats the determination in the step S11. In a case in which an abnormality score has been received, the control device 100 stores the received abnormality score in association with the point in time at which the abnormality score is received (step S12).

Further, the control device 100 determines whether a warning has been received from the information analysis device 3 (step S13). In a case in which a warning has not been received, the control device 100 causes the process to proceed to the step S15, described below. In a case in which a warning has been received, the control device 100 outputs a warning in the form of video or sound using the display unit or the speech output device of the substrate processing apparatus 1 (step S14).

Further, the control device 100 determines whether assistance information has been received from the assistance device 4 (step S15). In a case in which assistance information has not been received, the control device 100 causes the process to return to the step S15. In a case in which assistance information has been received, the control device 100 presents, based on the received assistance information, a maintenance work instruction corresponding to a maintenance subject component using the display device or the speech output device (step S16). Thereafter, the control device 100 causes the process to return to the step S10.

As shown in Fig. 6, the information analysis device 3 includes an information collector 31, a score calculator 32, a score transmitter 33 and a warning transmitter 34. The memory of the information analysis device 3 stores an abnormality determination program for determining an abnormality present in the substrate processing apparatus 1. The functions of the constituent elements (31 to 34) of the information analysis device 3 are implemented by execution of the abnormality determination program by the CPU of the information analysis device 3. Some or all of the constituent elements (31 to 34) of the information analysis device 3 of Fig. 6 may be realized by hardware such as an electronic circuit.

As shown in Fig. 8, the information collector 31 first collects a plurality of processing information pieces transmitted from the substrate processing apparatus 1 (step S20). Next, the score calculator 32 calculates a plurality of deviation degrees based on the plurality of collected processing information pieces (step S21), and transmits the plurality of calculated deviation degrees to the assistance device 4 (step S22). At this time, the score calculator 32 stores the plurality of deviation degrees calculated in the step S22 in the memory of the information analysis device 3.

Next, the score calculator 32 calculates an abnormality score of the substrate processing apparatus 1 based on the plurality of deviation degrees stored in the memory of the information analysis device 3 (step S23), and transmits the calculated abnormality score to the substrate processing apparatus 1 (step S24).

The memory of the information analysis device 3 stores the above-mentioned abnormality determination threshold value that is set in advance in accordance with the substrate processing apparatus 1. As such, the warning transmitter 34 determines whether the abnormality score calculated in the step S23 exceeds the abnormality determination threshold value (step S25). In a case in which the abnormality score does not exceed the abnormality determination threshold value, the warning transmitter 34 causes the process to return to the step S21. On the other hand, in a case in which the abnormality score exceeds the abnormality determination threshold value, the warning transmitter 34 transmits a warning to the substrate processing apparatus 1 (step S26), and causes the process to return to the step S20.

As shown in Fig. 6, the assistance device 4 includes a deviation degree acquirer 41, a subject determiner 42, a necessity value calculator 43, a level determiner 44, an instruction generator 45, a first storage 46, a second storage 47, a third storage 48 and an information updater 49. The memory of the assistance device 4 stores a maintenance assistance program for assisting the maintenance work for the substrate processing apparatus 1. The functions of the constituent elements (41 to 49) of the assistance device 4 are implemented by execution of the maintenance assistance program by the CPU of the assistance device 4. Some or all of the constituent elements (41 to 49) of the assistance device 4 of Fig. 6 may be realized by hardware such as an electronic circuit.

Before the substrate process is started by the substrate processing apparatus 1 of Fig. 6, the first storage 46 stores the data-related component information (Fig. 4) corresponding to the substrate processing apparatus 1 in advance. Further, before the substrate process is started by the substrate processing apparatus 1 of Fig. 6, the second storage 47 stores the temporal component information (Fig. 5) corresponding to the substrate processing apparatus 1 in advance. Further, before the substrate process is started by the substrate processing apparatus 1 of Fig. 6, the third storage 48 stores the content of a plurality of maintenance work instructions defined to respectively correspond to a plurality of levels of a maintenance necessity value in regard to each of a plurality of components of the substrate processing apparatus 1.

As described above, the data-related component information is defined by the maintenance worker, the administrator or the like. Further, the temporal component information changes over time. As such, as shown in Figs. 9 and 10, the information updater 49 determines whether the data-related component information stored in the first storage 46 has been changed (step S30). This determination is made based on whether an instruction for changing the data-related component information has been provided by the maintenance worker, the administrator or the like.

In a case in which the data-related component information has not been changed, the information updater 49 causes the process to proceed to the step S32, described below. On the other hand, when the data-related component information has been changed, the information updater 49 updates the data-related component information stored in the first storage 46 with newly changed data-related component information (step S31).

Next, the information updater 49 updates the temporal component information stored in the second storage 47 (step S32). This update process includes a process of updating an elapsed period of time, the number of failures and the number of operating components on the basis of a current point in time.

Next, the deviation degree acquirer 41 determines whether a plurality of deviation degrees have been received from the information analysis device 3 in regard to the substrate processing apparatus 1 of Fig. 6 (step S33). The memory of the assistance device 4 stores one or a plurality of deviation-degree threshold values that are preset in correspondence with the substrate processing apparatus 1. In the present example, the one or plurality of deviation-degree threshold values are common values. In a case in which the plurality of deviation degrees have not been received in the step S33, the deviation degree acquirer 41 causes the process to return to the step S30. On the other hand, when the plurality of deviation degrees have been received in the step S33, the deviation degree acquirer 41 determines whether each of these deviation degrees exceeds the predetermined deviation-degree threshold value, and extracts a deviation degree that exceeds the deviation-threshold value (step S34).

Next, the subject determiner 42 determines a maintenance subject component based on the extracted deviation degree and the data-related component information stored in the first storage 46 (step S35). Specifically, the subject determiner 42 determines, in regard to each of the one or plurality of deviation degrees extracted in the step S34, the component commonly related to two processing information pieces used for calculation of the deviation degree as a maintenance subject component.

Next, the necessity value calculator 43 calculates a maintenance necessity value of the maintenance subject component based on the determined maintenance subject component and the temporal component information stored in the second storage 47 (step S36). Specifically, in regard to each of the one or plurality of maintenance subject components determined in the step S35, the necessity value calculator 43 calculates a maintenance necessity value by using the temporal component information of the maintenance subject component and a predetermined arithmetic expression (the above-mentioned formula (1), for example).

Next, the instruction generator 45 generates assistance information corresponding to the maintenance subject component based on the maintenance necessity value calculated in the process of the step S36 (step S37). Specifically, in regard to each of the one or plurality of maintenance subject components, the level determiner 44 of Fig. 6 first determines which one of the plurality of predetermined levels the calculated maintenance necessity value belongs to. Thereafter, in regard to each of the one or plurality of maintenance subject components, the instruction generator 45 extracts the content of the maintenance work instruction corresponding to the level of the maintenance necessity value from the content of the plurality of maintenance work instructions stored in the third storage 48 and generates the assistance information. Finally, the instruction generator 45 transmits the generated assistance information to the substrate processing apparatus 1 of Fig. 6 (step S38), and causes the process to return to the step S30.

In the above-mentioned example, the series of processes shown in Fig. 8 is executed only on one substrate processing apparatus 1 of Fig. 6. In contrast, in a case in which the substrate processing apparatus management system 2 manages a plurality of substrate processing apparatuses 1, the series of processes shown in Fig. 8 is executed sequentially or in parallel on the plurality of substrate processing apparatuses 1, for example.

Further, the series of processes shown in Figs. 9 and 10 is executed only on the one substrate processing apparatus 1 of Fig. 6. In contrast, in a case in which the substrate processing apparatus management system 2 manages a plurality of substrate processing apparatuses 1, the series of processes shown in Figs. 9 and 10 is executed sequentially or in parallel on the plurality of substrate processing apparatuses 1, for example.

### 8. Effects of Embodiment

In the information analysis device 3, in regard to each of one or plurality of substrate processing apparatuses 1, an abnormality degree of the substrate processing apparatus 1 is calculated as an abnormality score based on the invariant relationships in regard to a plurality of processing information pieces and a plurality of actually collected processing information pieces. In a case in which the abnormality score exceeds the abnormality determination threshold value, a warning is transmitted to the substrate processing apparatus 1. When the abnormality score is calculated, the degree of deviation between one processing information predicted based on invariant information and an actually collected processing information piece is calculated, in regard to each of a plurality of combinations including two predetermined different processing information pieces.

In the assistance device 4, based on a plurality of deviation degrees calculated by the information analysis device 3 and data-related component information, one or a plurality of maintenance subject components are appropriately determined from among a plurality of components included in the substrate processing apparatus 1.

Further, in regard to each of the one or plurality of determined maintenance subject components, a maintenance necessity value is calculated based on temporal component information, and assistance information corresponding to the level of the calculated maintenance necessity value is generated. Thus, the maintenance worker for the substrate processing apparatus 1 can easily recognize a maintenance subject component based on the generated assistance information regardless of a degree of skill. Further, the maintenance worker can perform an appropriate maintenance work for the substrate processing apparatus 1 in a short period of time.

### 9. Other Embodiments

(1) While the plurality of substrate processing apparatuses 1Ato 1C of Fig. 1 have the same configurations, the present invention is not limited to this. Some or all of the plurality of substrate processing apparatuses 1A to 1C may have different configurations. Further, at least one of the plurality of substrate processing apparatuses 1A to 1C of Fig. 1 may be a single-wafer substrate cleaning device instead of a batch substrate cleaning device, or may have a configuration for performing a process other than a cleaning process. For example, the substrate processing apparatus 1 may be another substrate processing apparatus such as a coating device, a developing device, a heating device, a cooling device or a transfer device.
(2) In the substrate processing apparatus management system 2 according to the above-mentioned embodiment, the series of processes executed in the information analysis device 3 may be executed in the assistance device 4. Further, the series of processes executed in the information analysis device 3 may be executed in any one of the one or plurality of substrate processing apparatuses 1. In this case, the information analysis device 3 is not required.
(3) In the substrate processing apparatus management system 2 according to the above-mentioned embodiment, an abnormality score does not have to be transmitted to the substrate processing apparatus 1 from the information analysis device 3.
(4) A level is assigned to a degree of necessity for a maintenance work for a maintenance subject component in the substrate processing apparatus management system 2 according to the above-mentioned embodiment, and a maintenance necessity value is calculated for determination in regard to a maintenance work instruction corresponding to the level. However, the present invention is not limited to this.
   A maintenance necessity value does not have to be calculated. In this case, the assistance information including a plurality of maintenance work instructions that are considered for a determined maintenance subject component may be generated.
   Alternatively, a maintenance necessity value may be calculated based on another condition instead of the above-mentioned formula (1). For example, a maintenance necessity value may be an "elapsed period of time," the "number of failures," or a value obtained when an "elapsed period of time" is divided by "estimated years."
(5) In addition to or instead of the plurality of specific examples described in the above-mentioned embodiment, a plurality of processing information pieces may include at least one physical quantity from among a temperature in the processing chamber in which the substrate W is accommodated, a pressure in the processing chamber in which the substrate W is accommodated, a pressure of gas exhausted from the processing chamber in which the substrate W is accommodated, and a moving speed of a substrate transported by a robot. Further, the plurality of processing information pieces may include information in regard to at least one of a drive pulse signal for driving a robot that transports the substrate W and an output signal of a detector provided in the robot that transports the substrate W.
(6) In the above-mentioned embodiment, the first storage 46 of the assistance device 4 stores data-related component information corresponding to each of the one or plurality of substrate processing apparatuses 1. Further, the second storage 47 of the assistance device 4 stores the temporal component information corresponding to each of the one or plurality of substrate processing apparatuses 1. Further, the content of the plurality of maintenance work instructions are stored in the third storage 48 of the assistance device 4.
   However, the present invention is not limited to the above-mentioned example. Some or all of the data-related component information, the temporal component information and the content of the plurality of maintenance work instructions may be stored in another server provided outside of the assistance device 4. Alternatively, some or all of the data-related component information, the temporal component information and the content of the plurality of maintenance work instructions may be stored in the one or plurality of substrate processing apparatuses 1 or may be stored in the information analysis device 3. In this case, each of the subject determiner 42, the necessity value calculator 43 and the instruction generator 45 of the assistance device 4 acquire information necessary to achieve the function from outside of the assistance device 4.
(7) The assistance device 4 according to the above-mentioned embodiment may include an instruction output device that outputs a maintenance work instruction based on assistance information. In this case, the instruction output device may be a printer that prints the content of a maintenance work instruction on a paper medium, or a portable terminal that has a display that displays the content of a maintenance work instruction and is configured to be capable of wirelessly communicating with the CPU of the assistance device 4, for example. Alternatively, the instruction output device may be a speech output device that outputs the content of a maintenance work instruction by speech.
(8) In the assistance device 4, in a case in which report information is generated as assistance information, the assistance device 4 may include a report output device that outputs a report in regard to various maintenance works based on the assistance information. In this case, the report output device may be a printer that prints the report information on a paper medium, or a mobile terminal that has a display that displays the report information and is configured to be capable of wirelessly communicating with the CPU of the assistance device 4. Alternatively, the report output device may be a speech output device that outputs report information by speech.

### 10. Correspondences between Constituent Elements in Claims and Parts in Preferred Embodiments

In the following paragraphs, non-limiting examples of correspondences between various elements recited in the claims below and those described above with respect to various preferred embodiments of the present disclosure are explained. As each of various elements recited in the claims, various other elements having configurations or functions described in the claims can be also used.

In the above-mentioned embodiment, the substrate processing apparatuses 1, 1A to 1C are examples of a substrate processing apparatus, the assistance device 4 is an example of an assistance device, the deviation degree acquirer is an example of a deviation degree acquirer, the level determiner 44 and the instruction generator 45 are examples of an assistance information generator, the subject determiner 42 is an example of a subject determiner, the necessity value calculator 43 is an example of a necessity value calculator, and the CPU and the memory of the assistance device 4 are examples of a computer.

## Claims

1. An assistance device that assists a maintenance work for a substrate processing apparatus, comprising:
a deviation degree acquirer that acquires deviation degree information representing respective degrees of deviation between a plurality of respective processing information pieces and a plurality of actually collected respective processing information pieces, the plurality of respective processing information pieces being predicted based on invariant relationships in regard to a plurality of processing information pieces representing operations or states related to a process for a substrate in the substrate processing apparatus and a plurality of processing information pieces that are actually collected from the substrate processing apparatus; and
an assistance information generator that generates assistance information related to a maintenance work for the substrate processing apparatus based on the deviation degree information.

2. The assistance device according to claim 1, wherein
the substrate processing apparatus includes a plurality of components related to the plurality of processing information pieces,
the assistance device further includes a subject determiner that determines one or a plurality of components subject to the maintenance work from among the plurality of components based on the deviation degree information as one or a plurality of maintenance subject components, and
the assistance information includes information representing the one or plurality of maintenance subject components determined by the subject determiner.

3. The assistance device according to claim 2, wherein
a plurality of combinations each of which includes two different processing information pieces are defined in regard to the plurality of processing information pieces,
each combination includes a first processing information piece and a second information processing piece,
in regard to each combination, the first processing information piece that is predicted based on the second processing information piece actually collected from the substrate processing apparatus and the invariant relationship is generated as a first prediction processing information piece, and a degree of deviation between the generated first prediction processing information piece and the first processing information piece actually collected from the substrate processing apparatus is calculated as a first deviation degree,
in regard to each combination, the second processing information piece that is predicted based on the first processing information piece actually collected from the substrate processing apparatus and the invariant relationship is generated as a second prediction processing information piece, and a degree of deviation between the generated second prediction processing information piece and the second processing information piece actually collected from the substrate processing apparatus is calculated as a second deviation degree,
the deviation degree acquirer acquires a plurality of first deviation degrees that are respectively calculated in regard to the plurality of combinations, and a plurality of second deviation degrees that are respectively calculated in regard to the plurality of combinations as the deviation degree information, and
the subject determiner
extracts one or a plurality of combinations having the first deviation degrees exceeding a predetermined first threshold value, and one or a plurality of combinations having the second deviation degrees exceeding a predetermined second threshold value, and
in regard to each of the one or plurality of extracted combinations, determines one or a plurality of components commonly related to a first processing information piece and a second processing information piece included in the combination as the one or plurality of maintenance subject components.

4. The assistance device according to claim 2 or 3, further including a necessity calculator that, in regard to each of the one or plurality of maintenance subject components determined by the subject determiner, acquires information related to a state of the maintenance subject component that changes over time as temporal component information, and calculates a necessity value indicating a degree of necessity of the maintenance work for the maintenance subject component based on the acquired temporal component information, wherein
the assistance information generator, in regard to each of the one or plurality of maintenance subject components determined by the subject determiner, determines which one of a plurality of predetermined necessity levels the necessity value calculated by the necessity value calculator belongs to, and causes the assist information to include information about a predetermined maintenance work for the maintenance subject component according to the determined necessity level.

5. The assistance device according to any one of claims 1 to 4, wherein
each substrate processing apparatus is a substrate cleaning device that cleans a substrate using a cleaning liquid, and
the plurality of processing information pieces include at least one of an amount of cleaning liquid supplied to a substrate, a temperature of the cleaning liquid supplied to the substrate and a concentration of the cleaning liquid supplied to the substrate.

6. An assistance method of assisting a maintenance work for a substrate processing apparatus, including:
acquiring deviation degree information representing respective degrees of deviation between a plurality of respective processing information pieces and a plurality of actually collected respective processing information pieces, the plurality of respective processing information pieces being predicted based on invariant relationships in regard to a plurality of processing information pieces representing operations or states related to a process for a substrate in the substrate processing apparatus and a plurality of processing information pieces that are actually collected from the substrate processing apparatus; and
generating assistance information related to a maintenance work for the substrate processing apparatus based on the deviation degree information.

7. An assistance program that causes a computer to execute an assistance process of assisting a maintenance work for a substrate processing apparatus,
the assistance process including the processes of:
acquiring deviation degree information representing respective degrees of deviation between a plurality of respective processing information pieces and a plurality of actually collected respective processing information pieces, the plurality of respective processing information pieces being predicted based on invariant relationships in regard to a plurality of processing information pieces representing operations or states related to a process for a substrate in the substrate processing apparatus and a plurality of processing information pieces that are actually collected from the substrate processing apparatus; and
generating assistance information related to a maintenance work for the substrate processing apparatus based on the deviation degree information.
